# EUROPÄISCHE PATENTSCHRIFT

(11) **EP 4 173 451 B1**
(45) Veröffentlichungstag und Bekanntmachung des Hinweises auf die Patenterteilung: **24.09.2025**
(21) Anmeldenummer: 21734792.1
(22) Anmeldetag: 17.06.2021
(51) Int. Cl.: H05K 3/10, H01R 13/66

(54) **ELEKTRISCHER STECKVERBINDER**
ELECTRICAL PLUG CONNECTOR
CONNECTEUR ÉLECTRIQUE MÂLE

(30) Priorität: 29.06.2020 DE 102020117030
(43) Veröffentlichungstag der Anmeldung: 03.05.2023
(73) Patentinhaber: Turck Holding GmbH, 58553 Halver (DE)
(72) Erfinder: KREKLOW, Kevin, 79112 Freiburg (DE); SCHWAGMANN, Hermann, 32760 Detmold (DE)
(74) Vertreter: LBP Lemcke, Brommer & Partner Patentanwälte mbB
(86) Internationale Anmeldenummer: PCT/EP2021/066438
(87) Internationale Veröffentlichungsnummer: WO 2022/002615

(56) Entgegenhaltungen:
- EP-A1- 1 923 965
- EP-B1- 1 923 965
- WO-A1-2020/026057
- WO-A1-98/09486

## Beschreibung

Die Erfindung betrifft einen elektrischen Steckverbinder nach dem Oberbegriff des Anspruchs 1, mit eingangsseitigen Kontakten sowie einem Gehäuse, innerhalb dessen an die Kontakte elektrische Leitungen und eine elektrische Schaltung mit mindestens einer Sensoreinrichtung sowie einer Steuereinrichtung angeschlossen ist.

Elektrische Steckverbinder sind hinlänglich bekannt und werden vielfältig eingesetzt. Der Steckverbinder kann beispielsweise als Stecker, als Buchse oder als Kupplung ausgebildet sein. Dabei kann der Steckverbinder beispielsweise am Ende eines Kabels befestigt sein oder aber in einer anderen Ausbildungsform mit einem Ende an einer Leiterplatte angeschlossen sein. Die vorliegende Erfindung erfasst sämtliche Arten solcher Steckverbinder in unterschiedlichsten Varianten.

Einfach aufgebaute Steckverbinder bestehen in der Regel aus eingangsseitigen Kontakten und einem Gehäuse, innerhalb dessen an die Kontakte elektrische Leitungen angeschlossen sind. So kann beispielsweise ein Kabel, dessen einzelne Leitungen im Gehäuse des Steckverbinders mit den dortigen Kontakten elektrisch verbunden sind, in einfacher Weise an den Gegenstecker angeschlossen werden. Die Steckverbinder werden dabei auf den Gegenstecker gesteckt, geschraubt oder in ähnlicher Weise lösbar befestigt.

Zwischenzeitlich sind auch Steckverbinder bekannt geworden, die innerhalb ihres Gehäuses nicht nur elektrische Leitungen beinhalten, die an die Kontakte des Steckverbinders angeschlossen, sondern auch "intelligent" ausgebildet sind. Hierfür ist innerhalb des Gehäuses des elektrischen Steckverbinders eine elektrische Schaltung angeordnet, die beispielsweise Überwachungs- und Sensorfunktionen übernimmt, um die ordnungsgemäße Funktion des Steckverbinders sowie der über diese Steckverbinder übertragenen Signale sicherzustellen. Hierfür verfügt die elektrische Schaltung neben der Sensoreinrichtung auch eine Steuereinrichtung. Die Steuereinrichtung sorgt dafür, dass einerseits die zu überwachenden Parameter des Steckerbinders bzw. der Signale innerhalb des Steckverbinders analysiert und andererseits in geeigneter Weise drahtlos oder kontaktbehaftet an eine außerhalb des Steckverbinders liegende Auswerteeinrichtung abgegeben werden.

Beispiele solcher "intelligenten" Steckverbinder sind in DE 10 2017 107 251 A1, US 5,989,069, US 2016/0343232 A1 sowie WO 2018/222695 A1 offenbart.

Bei diesen bekannten, "intelligenten" Steckverbindern ist regelmäßig innerhalb des Gehäuses des Steckverbinders eine gewöhnliche, d. h. eine plattenförmige Leiterplatte, auf der eine elektrische Schaltung mit Steuereinrichtung aufgebracht ist, angeordnet. Die Sensoreinrichtung befindet sich dabei, wie beispielsweise die WO 2018/222695 A1 zeigt, nicht auf der zugehörenden Leiterplatte, auf der die Steuereinrichtung sitzt. Eine einfache Montage eines solchen "intelligenten" Steckverbinders ist deshalb nicht möglich. Erschwerend kommt hinzu, dass der in das Gehäuse des elektrischen Steckverbinders einzusetzende Trägerkörper neben der Leiterplatte und den Sensoren eine Vielzahl von weiteren Schaltungskomponenten aufnehmen muss. Hierzu gehören neben den einzelnen Steckverbinderkontakten sogenannte Kontaktkerne und Übertragerspulen. Sämtliche dieser Komponenten müssen in den Trägerkörper eingesetzt, dort befestigt und dieser dann noch mit einem separaten Deckel verschlossen werden. Letztlich muss dieser mit den einzelnen Komponenten ausgestattete und mit einem Deckel verschlossene Trägerkörper dann in das Gehäuse des Steckverbinders eingesetzt werden.

In der WO 98/09486 A1 ist ein elektronisches Steuergerät für einen Fahrzeug-Airbag in Form eines elektrischen Steckverbinders vorgeschlagen worden. In diesem sind elektrische Leitungen und eine elektronische Schaltung mit Sensoreinrichtungen an ausgangsseitige Steckverbinder-Kontakte angeschlossen. Wenn der Zünder für den Airbag auf diese Steckverbinder-Kontakte aufgesteckt ist, dient eine an eingangsseitige Kontakte angeschlossene Steuereinrichtung zum Auslösen des Zünders. Die elektronischen Bauteile sind auf einem gemeinsamen einstückigen Trägerkörper angeordnet. Dieser besteht aus einem Stanzgitter, das alle elektronischen Bauteile und alle Kontaktierungselemente inklusive der ausgangsseitigen Buchsen bzw. Stecker miteinander verbindet, und das mit Kunststoff umspritzt ist.

Der vorliegenden Erfindung liegt die Aufgabe zugrunde, einen "intelligenten" elektrischen Steckverbinder bereitzustellen, der aus wenigen Teilen besteht und folglich leicht zu handhaben und insbesondere leicht zu montieren ist.

Diese Aufgabe wird durch einen Steckverbinder mit den Merkmalen des Anspruchs 1 gelöst.

Weiterbildungen eines solchen Steckverbinders sind Gegenstand der auf den Anspruch 1 zurückbezogenen Unteransprüche.

Der elektrische Steckverbinder nach der Erfindung zeichnet sich also insbesondere dadurch aus, dass der elektrische Steckverbinder mit eingangsseitigen Kontakten sowie einem Gehäuse, innerhalb dem an die Kontakte elektrische Leitungen und eine elektrische Schaltung mit mindestens einer Sensoreinrichtung sowie einer Steuereinrichtung angeschlossen ist. Dabei sind die Sensoreinrichtung und die Steuereinrichtung auf einem gemeinsamen, einstückigen Trägerkörper angeordnet. Der Trägerkörper ist erfindungsgemäß als aus einem nichtmetallischen Werkstoff hergestellter und von einer Plattenform abweichender Schaltungsträger ausgebildet. Auf dem Trägerkörper sind metallische Leiterbahnen aufgebracht.

Der wesentliche Kern bei dem vorliegenden Steckverbinder liegt in einer besonderen Ausgestaltung des Trägerkörpers, welcher in das Gehäuse des elektrischen Steckverbinders nach der Erfindung einzusetzen ist.

Dieser Trägerkörper besteht vorzugsweise aus Kunststoff, allerdings kann der Trägerkörper auch aus einem anderen, elektrisch nicht leitenden Material bestehen, wie z. B. Keramik oder Glas, und ist einstückig, beispielsweise als Spritzgießteil, Sinterteil oder als 3D-Druckteil, hergestellt. Dabei weicht dieser Trägerkörper von einer herkömmlichen Plattenform, also einer lediglich ebenen Gestaltung, ab, beispielsweise dadurch, dass der Trägerkörper den eingangsseitigen Kontakten des Steckverbinders zugewandt eine an die Innenkontur des Gehäuses des Steckverbinders angepasste Außenkontur aufweist. Auf dem so ausgebildeten Trägerkörper sind metallische Leiterbahnen aufgebracht zur Kontaktierung der elektrischen Schaltung. Neben diesen elektrischen Leiterbahnen trägt der Trägerkörper erfindungsgemäß auch die elektrische Schaltung mit der Sensoreinrichtung und einer geeigneten Steuereinrichtung.

Für die Montage eines solchen Steckverbinders ist es in einfacher Weise lediglich notwendig, den als Schaltungsträger ausgebildeten Trägerkörper in das Gehäuse des elektrischen Steckverbinders einzusetzen sowie die elektrischen Leitungen an die eingangsseitigen Kontakte des Steckverbinders anzuschließen.

Der Trägerkörper weist nach der vorliegenden Erfindung außerdem geeignete Befestigungsmittel auf, mit welchen der Trägerkörper unmittelbar im Gehäuse des Steckverbinders befestigt ist. Hierfür sind Schraubgewinde am Trägerkörper und am Gehäuse des Steckverbinders vorgesehen. Der Trägerkörper weist hierfür in geeigneter Weise auf seiner Außenseite ein Außengewinde auf, das in ein passendes Innengewinde, das an den Innenumfang des Gehäuses des Steckverbinders eingearbeitet ist, einschraubbar ist.

Erfindungsgemäß besteht der einstückig ausgebildete Trägerkörper im Wesentlichen aus mehreren, einstückig aneinander gebundenen Abschnitten, und zwar zwei äußeren Abschnitten (erste und zweite Abschnitte) und einem dritten, mittleren Abschnitt. Dieser mittlere Abschnitt ist plattenförmig ausgebildet und trägt die notwendigen Schaltungskomponenten der elektrischen Schaltung. Die an diesem plattenförmigen Abschnitt angebundenen beiden äußeren Abschnitte sind dagegen so gestaltet, dass sie sich der Innenkontur des Gehäuses des Steckverbinders mindestens weitgehend anpassen, um dort in einfacher Weise befestigt zu werden. Hierfür sind beispielsweise die oben genannten Schraubverbindungen geeignet.

In einer Weiterbildung der Erfindung ist vorgesehen, dass das Gehäuse des Steckverbinders den Trägerkörper vollständig umgibt.

In einer anderen Weiterbildung ist vorgesehen, dass das Gehäuse einteilig oder zweiteilig mit einem ersten Gehäuseteil und einem zweiten Gehäuseteil ausgebildet ist. Im Falle eines zu realisierenden sogenannten Rundsteckers, ist das Gehäuse des elektrischen Steckverbinders mit einer zylindrischen Außenform versehen und insbesondere als M8- oder M12-Rundgehäuse ausgebildet. Andere M-Varianten sind selbstverständlich ebenfalls möglich.

In einer anderen Weiterbildung der Erfindung ist vorgesehen, dass die Sensoreinrichtung nicht auf dem plattenförmigen Abschnitt des Trägerkörpers angeordnet ist, sondern in einem Bereich des Trägerkörpers, der möglichst nahe an die Gehäusewand des Steckverbinders reicht. Dadurch ist gewährleistet, dass die Sensoreinrichtung die unmittelbar an der Außenwand des Steckverbinders anstehende Umgebungsbedingung (z.B. Temperatur, Feuchte oder Druck etc.) ermitteln kann. Zweckmäßigerweise wird dafür korrespondierend zur Anordnung der Sensoreinrichtung eine Öffnung im Gehäuse des Steckverbinders platziert.

Die elektrische Schaltung des erfindungsgemäßen Steckverbinders ist zusammen mit der Sensoreinrichtung dafür vorgesehen, verschiedene Betriebsbedingungen des Steckverbinders bzw. der durch den Steckverbinder geführten Signale oder ähnlichem zu überwachen. Dafür ist es notwendig, dass die elektrische Schaltung auch eine Kommunikationseinrichtung beinhaltet, mit der die erfassten Parameter an eine Auswerteeinrichtung außerhalb des Steckverbinders übertragen werden können. Hierfür verfügt die elektrische Schaltung des Steckverbinders über eine geeignete Kommunikationseinrichtung, z. B. eine Bluetooth-Verbindung oder einer Mobilfunk-Verbindung. Die übertragenen Signale können dann von einer geeigneten Empfängereinrichtung empfangen und ausgewertet werden.

Für eine Stromversorgung der elektrischen Schaltung innerhalb des elektrischen Steckverbindergehäuses ist es zweckmäßig, die elektrische Schaltung elektrisch an die eingangsseitigen Kontakte des Steckverbinders anzuschließen, da dort elektrische Signale übertragen werden, die zur Stromversorgung für die elektrische Schaltung innerhalb des Steckverbinders ausgenutzt werden. Hierfür können elektrisch leitende Federelemente, insbesondere lötbare Federelemente am Trägerkörper vorgesehen werden, die an die Kontakte und/oder elektrische Leitungen des Steckverbinders angeschlossen sind. Darüber hinaus kann es vorteilhaft sein, eine Spannungsregelungseinrichtung innerhalb des Steckverbindergehäuses vorzusehen, um die elektrische Schaltung geregelt mit Versorgungsspannung versorgen zu können.

Der Steckverbinder nach der vorliegenden Erfindung wird anhand eines Ausführungsbeispiels im Zusammenhang mit drei Figuren anschließen näher erläutert. Es zeigen:
- Figur 1: die Außenansicht auf einen elektrischen Steckverbinder nach der vorliegenden Erfindung,
- Figur 2: den elektrischen Steckverbinder von Figur 1 in teilweise aufgebrochener Ansicht, und
- Figur 3: den Steckverbinder der Figuren 1 und 2 in Explosionsdarstellung.

In den nachfolgenden Figuren bezeichnen gleiche Bezugszeichen gleich Teile mit gleicher Bedeutung, sofern nicht anders angegeben.

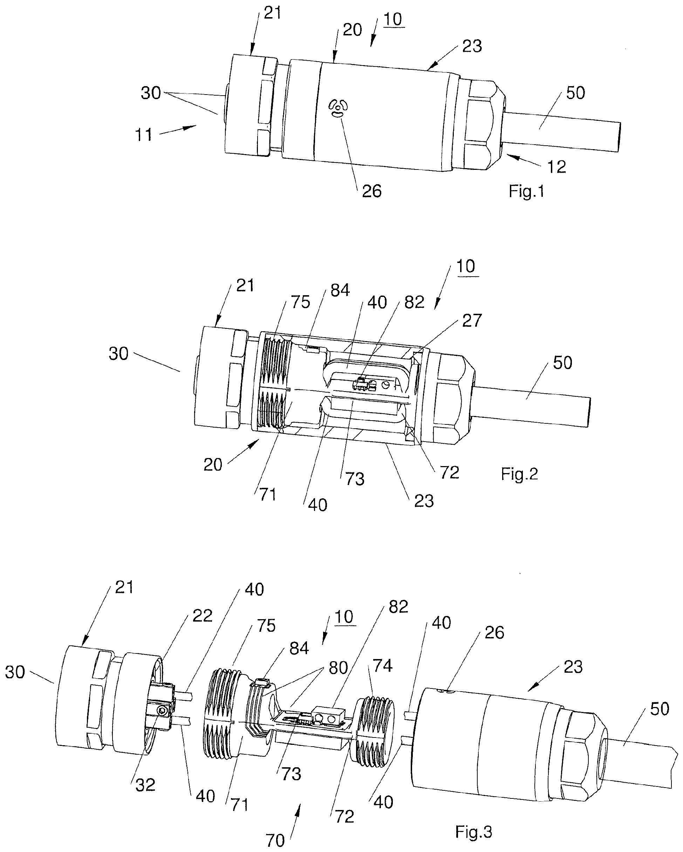

Figur 1 zeigt ein Ausführungsbeispiel eines elektrischen Steckverbinders in seitlicher Draufsicht. Der Steckverbinder ist als elektrischer Rundstecker ausgebildet. Der Steckverbinder ist mit dem Bezugszeichen 10 versehen und weist eine vordere Steckseite 11 und eine hierzu abgewandte Rückseite 12 auf. Der Steckverbinder 10 verfügt über ein zylinderförmiges Gehäuse 20 mit einem zur Steckseite 11 zugewandten ersten Gehäuseteil 21 sowie einem hierzu längeren, zweiten Gehäuseteil 23. Die beiden Gehäuseteile 21 und 22 können beispielsweise über eine Schraubverbindung mit einem in Figur 3 angedeuteten Innengewinde 22 und einem in den Figuren nicht dargestellten Außengewinde am Gehäuseteil 23 versehen sein. Das Gehäuse 20, vorliegend das zweite Gehäuseteil 23 verfügt an seiner Wandung über eine Öffnung, auf deren Bedeutung noch nachfolgend eingegangen wird.

Aus der der Steckseite 11 ragen Kontakte 30 heraus, die die Steckkontakte des Steckverbinders 10 bilden. Diese Kontakte 30 sind im Inneren des Gehäuses 20 des Steckverbinders 10 an Kontaktlaschen 32 und über elektrische Leitungen 40 mit einem an der Rückseite 12 des Steckverbinders 10 herausragenden Kabels 50 elektrisch in Verbindung. Hierfür können beispielsweise elektrische Leitungen 40 des Kabels 50 mittels Crimpverbindungen, Schraubverbindungen, Lösverbindungen oder dergleichen an die Kontaktlaschen 32 im Innern des Gehäuses 20 angeschlossen sein. Die Kontaktlaschen 32 sind elektrisch leitend mit den Kontakten 30 verbunden.

Wie insbesondere die Schnittdarstellung von Figur 2 und die perspektivische Darstellung von Figur 3 zeigen, befindet sich innerhalb des Gehäuses 20 des Steckverbinders 10 ein besonders gestalteter Trägerkörper 70. Dieser Trägerkörper 70 besteht aus einem elektrisch nicht leitenden Material, vorzugsweise Kunststoff und ist mittels Spritzgießens oder 3D-Druck hergestellt. Der Trägerkörper 70 ist somit elektrisch nicht leitend. Der Trägerkörper 70 weist im dargestellten Ausführungsbeispiel drei einstückig aneinandergefügte Abschnitte 71, 72 und 73 auf. Der mittlere Abschnitt 73 ist plattenförmig gestaltet zur Aufnahme von elektrischen Schaltungskomponenten einer elektrischen Schaltung. Die einzelnen Schaltungskomponenten sind allgemein mit dem Bezugszeichen 82 für eine Steuereinrichtung bezeichnet. An diesem mittleren Abschnitt 73 des Trägerkörpers 70 schließt sich in der Darstellung der Figuren 2 und 3 links ein erster äußerer Abschnitt 71 des Trägerkörpers und rechts ein zweiter äußerer Abschnitt 72 des Trägerkörpers 70 an. Der plattenförmige Abschnitt des Trägerkörpers 70 wird als mittlerer Abschnitt 73 bezeichnet. Der Trägerkörper 70 ist in seinem mittleren Abschnitt 73 und teilweise auch in seinem ersten äußeren Abschnitt 71 mit elektrischen Leitungen 80 versehen. Diese elektrischen Leitungen 80 können als Metallisierungen mit einer geeigneten Abscheidetechnik auf den Trägerkörper 70 nach Herstellung des Trägerkörpers 70 aufgebracht werden. Anstelle einer Abscheidung der Metallisierung zur Bildung der elektrischen Leitungen 80 ist es auch möglich, mittels elektrischer Leitpaste die erforderlichen elektrischen Leitungen 80 auf dem Trägerkörper 70 zu platzieren.

Wie die Figur 3 besonders deutlich erkennen lässt, sind der erste äußere Abschnitt 71 und der zweite äußere Abschnitt 72 des Trägerkörpers 70 an die Innenkontur des Gehäuses 20 des Steckverbinders angepasst, indem der erste äußere Abschnitt 71 und der zweite äußere Abschnitt 72 zylindrisch bzw. hohlzylindrisch ausgebildet sind und in etwa dem Innendurchmesser des rund ausgebildeten Gehäuses 20 des Steckverbinders 10 entsprechen. An diesem zylindrisch ausgebildeten, ersten äußeren Abschnitt 71 und zweiten äußeren Abschnitt 72 sind jeweils Außengewinde 75, 74 angeformt, damit der Trägerkörper 70 zusammen mit der elektrischen Schaltung in einfacher Weise in das Gehäuse 20 des Steckverbinders 10 eingeschraubt werden kann, sodass eine gute mechanische Verbindung zwischen dem Gehäuse 20 und dem Trägerkörper 70 gewährleistet ist.

Die auf dem Trägerkörper 70 aufgebrachte elektrische Schaltung ist dazu vorgesehen, unterschiedlichste Parameter des Steckverbinders, der darin fließenden Ströme sowie der Umgebungsbedingungen zu erfassen. Hierfür verfügt die elektrische Schaltung über eine Steuereinrichtung 82, die mit einer geeigneten Sensoreinrichtung 84 elektrisch in Verbindung steht. Die elektrische Sensoreinrichtung 84, die beispielsweise ein Temperatursensor sein kann, ist dabei nicht auf dem plattenförmig ausgebildeten mittleren Abschnitt 73 des Trägerkörpers 70 platziert, sondern auf einem Rücksprung des zylindrischen, ersten äußeren Abschnitts 71, wie in Figur 3 deutlich zu erkennen ist. Die Sensoreinrichtung 84 ist somit nahe an der Gehäusewand des Gehäuses 20 platziert. Damit die Sensoreinrichtung 84 optimal die Umgebungsbedingungen des Steckverbinders 10, z. B. die Temperatur oder Feuchte oder dergleichen, erfassen kann, verfügt das Gehäuse 20 über die oben bereits erwähnte Öffnung 26, unterhalb der die Sensoreinrichtung 84 platziert ist. Die Sensoreinrichtung 84 ist über die elektrischen Leitungen 80, die auf den ersten Abschnitt 21 aufgebracht sind, mit der elektrischen Schaltungsanordnung bzw. der elektrischen Steuereinrichtung 82 elektrisch in Verbindung.

Die Stromversorgung der gesamten elektrischen Schaltung auf dem Trägerkörper 70 erfolgt durch geeignete, in den Figuren nicht dargestellte elektrische Anschlüsse bzw. elektrische Zuleitungen, die mit den Kontakten 30 bzw. Kontaktlaschen 32 elektrisch in Verbindung stehen. Hierfür können z. B. lötbare Federkontakte vorgesehen sein, die bei dem Zusammenbau des Trägerkörpers 70 in das Gehäuse 20 des Steckverbinders 10 die Kontaktlaschen 32 federnd berühren und dort für einen Spannungsabgriff sorgen. Um Spannungsschwankungen auszugleichen, verfügt die elektrische Schaltung vorzugsweise über eine Spannungsregeleinrichtung.

Abschließend ist noch der Vollständigkeitshalber zu erwähnen, dass das Kabel 50 einzelne elektrische Leitungen 40 aufweist, die im Inneren des Gehäuses 20 des Steckverbinders 10 an die Kontaktlaschen 32 angeschlossen sind.

### Bezugszeichenliste:

- 10: Steckverbinder
- 11: Steckseite
- 12: Rückseite
- 20: Gehäuse
- 21: erstes Gehäuseteil
- 22: Innengewinde
- 23: zweites Gehäuseteil
- 26: Öffnung
- 27: Dichtring
- 30: Kontakte
- 32: Kontaktlaschen
- 40: elektrische Leitung
- 50: Kabel
- 70: Trägerkörper
- 71: erster äußerer Abschnitt des Trägerkörpers
- 72: zweiter äußerer Abschnitt des Trägerkörpers
- 73: mittlerer Abschnitt des Trägerkörpers
- 74: Außengewinde
- 75: Außengewinde
- 80: elektrische Leitungen
- 82: Steuereinrichtung
- 84: Sensoreinrichtung

## Patentansprüche

1. Elektrischer Steckverbinder (10) mit eingangsseitigen Kontakten (30) sowie einem Gehäuse (20), innerhalb dessen an die Kontakte (30) elektrische Leitungen (40) und eine elektrische Schaltung mit mindestens einer Sensoreinrichtung (84) sowie einer Steuereinrichtung (82) angeschlossen ist,
wobei die Sensoreinrichtung (84) und die Steuereinrichtung (82) auf einem gemeinsamen einstückigen Trägerkörper(70) angeordnet sind, und der Trägerkörper (70) als aus einem nicht metallischen Werkstoff hergestellter und von einer Plattenform abweichender Schaltungsträger ausgebildet ist, auf welchem metallische Leiterbahnen (80) aufgebracht sind, **dadurch gekennzeichnet,**
**dass** der Trägerkörper (70) Befestigungsmittel aufweist, mit welchem der Trägerkörper (70) unmittelbar am Gehäuse (20) des Steckverbinders (10) befestigt ist.
**dass** die Befestigungsmittel des Trägerkörpers (70) Schraubgewinde sind, welche zumindest abschnittsweise auf einer Außenseite des Trägerkörpers (70) angeordnet und in ein Innengewinde des Gehäuses (20) des Steckverbinders (10) einschraubbar sind,
und **dass** der Trägerkörper (70) im Wesentlichen aus drei einstückig aneinander gebundenen Abschnitten (71, 72, 73) besteht, wobei die zwei äußeren Abschnitte (71, 72) im Wesentlichen hohlzylinderförmig ausgebildet sind und mit einem mittleren, plattenförmigen Abschnitt (73) verbunden sind.

2. Elektrischer Steckverbinder (10) nach Anspruch 1,
**dadurch gekennzeichne**t, dass der Trägerkörper (70) als Spritzgießteil, als 3D-Druckteil oder als Sinterteil ausgebildet ist.

3. Elektrischer Steckverbinder (10) nach Anspruch 2,
**dadurch gekennzeichnet, dass** der Trägerkörper (70) den eingangseitigen Kontakten (30) zugewandt eine äußere Kontur aufweist, die zumindest annähernd an eine Innenkontur des Gehäuses (20) angepasst ist.

4. Elektrischer Steckverbinder (10) nach einem der Ansprüche 1 bis 3, **dadurch gekennzeichnet, dass** das Gehäuse (20) den Trägerkörper (70) vollständig umgibt.

5. Elektrischer Steckverbinder (10) nach einem der Ansprüche 1 bis 4, **dadurch gekennzeichnet, dass** das Gehäuse (20) einteilig oder zweiteilig mit einem ersten Gehäuseteil (21) und einem zweiten Gehäuseteil (23) ausgebildet ist.

6. Elektrischer Steckverbinder nach einem der Ansprüche 1 bis 5, **dadurch gekennzeichnet, dass** das Gehäuse (20) eine zylindrische Außenform aufweist und insbesondere als M8 oder M12-Rundgehäuse ausgebildet ist.

7. Elektrischer Steckverbinder nach einem der Ansprüche 1 bis 6, **dadurch gekennzeichnet, dass** auf dem mittleren, plattenförmigen Abschnitt (73) die Steuereinrichtung (82) der elektrischen Schaltung angeordnet ist.

8. Elektrischer Steckverbinder nach einem der Ansprüche 1 bis 7, **dadurch gekennzeichnet, dass** die Sensoreinrichtung (84) auf einer Außenwandung des ersten, hohlzylindrischen Abschnitts (71) des Trägerkörpers (70) angeordnet ist.

9. Elektrischer Steckverbinder nach einem der vorhergehenden Ansprüche, **dadurch gekennzeic**h**ne**t, dass auf den beiden äußeren Abschnitten (74, 75) des Trägerkörpers (70) jeweils ein Außengewinde einstückig eingearbeitet ist.

10. Elektrischer Steckverbinder nach einem der Ansprüche 1 bis 9, **dadurch gekennzeichnet, dass** das Gehäuse (20) eine am Außenumfang angeordnete Öffnung (26) aufweist, unterhalb der die Sensoreinrichtung (84) der elektrischen Schaltung platziert ist.

11. Elektrischer Steckverbinder nach einem der Ansprüche 1 bis 10, **dadurch gekennzeichnet, dass** die elektrische Schaltung eine drahtlose oder drahtgebundene Kommunikationseinrichtung aufweist.

12. Elektrischer Steckverbinder nach einem der Ansprüche 1 bis 11, **dadurch gekennzeichnet, dass** die elektrische Schaltung über elektrisch leitende Verbindungen an die elektrischen Leitungen (40) des Steckverbinders (10) angeschlossen sind.

13. Elektrischer Steckverbinder nach Anspruchs 12,
**dadurch gekennzeichnet, dass** die elektrisch leitenden Verbindungen durch elektrisch leitende Federelemente, insbesondere lötbare Federelemente, an die Kontakte (30) und/oder elektrischen Leitungen (40) des Steckverbinders (10) angeschlossen sind.

14. Elektrischer Steckverbinder nach einem der Ansprüche 1 bis 13, **dadurc**h **gekennzeichne**t, dass die elektrische Schaltung eine Spannungsregeleinrichtung aufweist

## Claims

1. Electrical plug connector (10) having contacts (30) on the input side and a housing (20) within which electrical lines (40) and an electrical circuit with at least one sensor device (84) and a control device (82) are connected to the contacts (30),
wherein the sensor device (84) and the control device (82) are arranged on a common, one-piece carrier body (70), and the carrier body (70) is formed as a circuit carrier made of a non-metal material and deviating from a plate shape, to which metal conductor tracks (80) are applied,
**characterized**
**in that** the carrier body (70) has fastening means with which the carrier body (70) is fastened directly to the housing (20) of the plug connector (10),
**in that** the fastening means of the carrier body (70) are screw threads which are arranged at least in portions on an outer side of the carrier body (70) and can be screwed into an internal thread of the housing (20) of the plug connector (10),
and **in that** the carrier body (70) consists substantially of three portions (71, 72, 73) integrally attached to one another, wherein the two outer portions (71, 72) are substantially hollow-cylindrical and are connected to a middle, plate-like portion (73).

2. Electrical plug connector (10) according to Claim 1,
**characterized in that** carrier body (70) is formed as an injection-moulded part, as a 3D-printed part or as a sintered part.

3. Electrical plug connector (10) according to Claim 2,
**characterized in that** the carrier body (70), facing the input-side contacts (30), has an outer contour that is at least approximately adapted to an inner contour of the housing (20).

4. Electrical plug connector (10) according to any of Claims 1 to 3,
**characterized in that** the housing (20) completely surrounds the carrier body (70).

5. Electrical plug connector (10) according to any of Claims 1 to 4,
**characterized in that** the housing (20) is formed in one part or two parts with a first housing part (21) and a second housing part (23).

6. Electrical plug connector according to any of Claims 1 to 5,
**characterized in that** the housing (20) has a cylindrical outer shape and is formed in particular as an M8 or M12 round housing.

7. Electrical plug connector according to any of Claims 1 to 6,
**characterized in that** the control device (82) of the electrical circuit is arranged on the middle, plate-like portion (73).

8. Electrical plug connector according to any of Claims 1 to 7,
**characterized in that** the sensor device (84) is arranged on an outer wall of the first, hollow-cylindrical portion (71) of the carrier body (70).

9. Electrical plug connector according to any of the preceding claims,
**characterized in that** an external thread is integrally machined on each of the two outer portions (74, 75) of the carrier body (70).

10. Electrical plug connector according to any of Claims 1 to 9,
**characterized in that** the housing (20) has an opening (26) which is arranged at the outer circumference and below which the sensor device (84) of the electrical circuit is placed.

11. Electrical plug connector according to any of Claims 1 to 10,
**characterized in that** the electrical circuit comprises a wireless or wired communication device.

12. Electrical plug connector according to any of Claims 1 to 11,
**characterized in that** the electrical circuit is connected to the electrical lines (40) of the plug connector (10) via electrically conductive connections.

13. Electrical plug connector according to Claim 12, **characterized in that** the electrically conductive connections are connected to the contacts (30) and/or electrical lines (40) of the plug connector (10) by electrically conductive spring elements, in particular solderable spring elements.

14. Electrical plug connector according to any of Claims 1 to 13,
**characterized in that** the electrical circuit comprises a voltage regulation device.

## Revendications

1. Connecteur enfichable électrique (10) comprenant des contacts côté entrée (30) ainsi qu'un boîtier (20) à l'intérieur duquel des lignes électriques (40) et un circuit électrique, comportant au moins un dispositif capteur (84) ainsi qu'un dispositif de commande (82), sont raccordées aux contacts (30),
le dispositif capteur (84) et le dispositif de commande (82) étant disposés sur un corps porteur (70) monobloc commun, et le corps porteur (70) étant réalisé sous la forme d'un porte-circuit fabriqué dans un matériau non métallique et s'écartant d'une forme de plaque, sur lequel sont appliquées des pistes conductrices métalliques (80),
**caractérisé en ce**
**que** le corps porteur (70) possède des moyens de fixation avec lesquels le corps porteur (70) est fixé directement au boîtier (20) du connecteur enfichable (10),
**que** les moyens de fixation du corps porteur (70) sont des filetages, lesquels sont disposés au moins par portions sur un côté extérieur du corps porteur (70) et peuvent être vissés dans un filetage femelle du boîtier (20) du connecteur enfichable (10),
et **que** le corps porteur (70) est pour l'essentiel constitué de trois portions (71, 72, 73) reliées entre elles d'un seul tenant, les deux portions extérieures (71, 72) étant sensiblement de forme cylindrique creuse et étant reliées à une portion centrale (73) en forme de plaque.

2. Connecteur enfichable électrique (10) selon la revendication 1,
**caractérisé en ce que** le corps porteur (70) est réalisé sous la forme d'une pièce moulée par injection, d'une pièce imprimée en 3D ou d'une pièce frittée.

3. Connecteur enfichable électrique (10) selon la revendication 2,
**caractérisé en ce que** le corps porteur (70) présente, en regard des contacts d'entrée (30), un contour extérieur qui est au moins approximativement adapté à un contour intérieur du boîtier (20).

4. Connecteur enfichable électrique (10) selon l'une des revendications 1 à 3,
**caractérisé en ce que** le boîtier (20) entoure complètement le corps porteur (70).

5. Connecteur enfichable électrique (10) selon l'une des revendications 1 à 4,
**caractérisé en ce que** le boîtier (20) est réalisé en une seule pièce ou en deux parties avec une première partie de boîtier (21) et une deuxième partie de boîtier (23).

6. Connecteur enfichable électrique selon l'une des revendications 1 à 5,
**caractérisé en ce que** le boîtier (20) présente une forme extérieure cylindrique et est notamment réalisé sous la forme d'un boîtier rond M8 ou M12.

7. Connecteur enfichable électrique selon l'une des revendications 1 à 6,
**caractérisé en ce que** le dispositif de commande (82) du circuit électrique est disposé sur la portion centrale (73) en forme de plaque.

8. Connecteur enfichable électrique selon l'une des revendications 1 à 7,
**caractérisé en ce que** le dispositif capteur (84) est disposé sur une paroi extérieure de la première portion cylindrique creuse (71) du corps porteur (70).

9. Connecteur enfichable électrique selon l'une des revendications précédentes,
**caractérisé en ce qu'**un filetage extérieur est respectivement incorporé d'un seul tenant sur les deux portions extérieures (74, 75) du corps porteur (70).

10. Connecteur enfichable électrique selon l'une des revendications 1 à 9,
**caractérisé en ce que** le boîtier (20) possède une ouverture (26) disposée sur le pourtour extérieur, sous laquelle est placé le dispositif capteur (84) du circuit électrique.

11. Connecteur enfichable électrique selon l'une des revendications 1 à 10,
**caractérisé en ce que** le circuit électrique possède un dispositif de communication sans fil ou filaire.

12. Connecteur enfichable électrique selon l'une des revendications 1 à 11,
**caractérisé en ce que** le circuit électrique est raccordé aux lignes électriques (40) du connecteur enfichable (10) par le biais de liaisons électriquement conductrices.

13. Connecteur enfichable électrique selon la revendication 12,
**caractérisé en ce que** les liaisons électriquement conductrices sont reliées aux contacts (30) et/ou aux lignes électriques (40) du connecteur enfichable (10) par des éléments ressorts électriquement conducteurs, en particulier des éléments ressorts soudables.

14. Connecteur enfichable électrique selon l'une des revendications 1 à 13,
**caractérisé en ce que** le circuit électrique possède un dispositif de régulation de tension.
